(19) **Europäisches Patentamt**
**European Patent Office**
**Office européen des brevets**

(11) **EP 2 171 839 B1**

(12) **EUROPEAN PATENT SPECIFICATION**

(45) Date of publication and mention
of the grant of the patent:
**11.07.2012 Bulletin 2012/28**

(21) Application number: **08776495.7**

(22) Date of filing: **25.06.2008**

(51) Int Cl.:
***H03F 3/347*** (2006.01)    ***H03F 1/30*** (2006.01)

(86) International application number:
**PCT/IB2008/052536**

(87) International publication number:
**WO 2009/004534 (08.01.2009 Gazette 2009/02)**

(54) **ELECTRONIC DEVICE AND A METHOD OF BIASING A MOS TRANSISTOR IN AN INTEGRATED CIRCUIT**

ELEKTRONISCHE VORRICHTUNG UND VERFAHREN ZUR VORSPANNUNG EINES MOS-TRANSISTORS IN EINER INTEGRIERTEN SCHALTUNG

DISPOSITIF ÉLECTRONIQUE ET PROCÉDÉ DE POLARISATION D'UN TRANSISTOR MOS DANS UN CIRCUIT INTÉGRÉ

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **03.07.2007 EP 07111637**

(43) Date of publication of application:
**07.04.2010 Bulletin 2010/14**

(73) Proprietor: **ST-Ericsson SA**
**1228 Plan-les-Ouates (CH)**

(72) Inventor: **WANG, Zhenhua**
**8424 Embrach (CH)**

(74) Representative: **Dossmann, Gérard**
**Casalonga & Partners**
**Bayerstrasse 71-73**
**80335 München (DE)**

(56) References cited:
**EP-A- 0 476 365      EP-A- 1 081 573**
**EP-A- 1 855 379      US-A- 6 034 519**
**US-A- 6 087 820      US-B1- 6 492 874**

**Description**

FIELD OF THE INVENTION

The present invention relates to an electronic device and a method of biasing a MOS transistor in an integrated circuit.

BACKGROUND OF THE INVENTION

Mobile devices like mobile phones are becoming more and more complex as they have to be able to support a plurality of multimedia applications. As a result, power consumption increases significantly and battery lifetime is shortened, putting more pressure on circuit designers to take measures to reduce the power consumption of not only digital circuits but also of analog circuits.

For digital circuits such as a baseband digital signal processor DSP in mobile devices, various low-power techniques can be used including multi-$V_T$, clock gating, multi-supply voltage, power shut-off, substrate biasing, dynamic voltage scaling and adaptive supply voltage scaling. Among these, the adaptive supply voltage scaling has proven to be an efficient way to reduce the power consumption due to the fact that dynamic power consumption decreases with the square of the supply voltage.

By contrast, a generally applicable technique for reducing the power consumption of analog circuits is not available. In analogue circuits, power consumption is required to maintain signal energy above the fundamental thermal noise to achieve the required signal-to-noise ratio. At a give temperature, the minimum power consumption of analog circuits is set by the required signal-to-noise ratio and the required bandwidth. Hence, decreasing the supply voltage, similarly as with the adaptive supply voltage scaling for digital circuits, will not lead to power reduction in analog circuits.

For most applications MOS transistors are typically biased in the saturation region to provide the required gain and bandwidth. The biasing is usually established by the drain-to-source current Ids through the MOS transistor by means of a biasing circuitry.

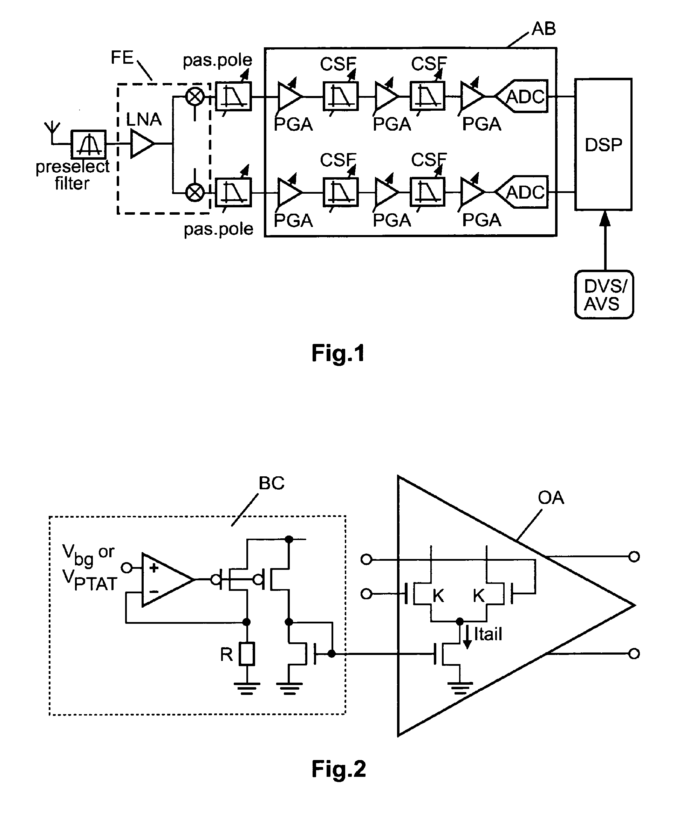

Fig. 1 shows a schematic diagram of a heterodyne UMTS receiver according to the prior art. The receiver comprises a RF CMOS front-end circuit FE and an analog baseband circuit AB. The input signal is received by the antenna and conversion down to baseband is applied. The analog baseband comprises two identical I- and Q-channels. The wanted channels are amplified and selected in analog domain and further processed by the digital signal processor DSP. Each of the I- and Q-channels comprises programmable gain amplifier PGA, channel selection filters CSF and an analog/digital converter ADC. As an example, the implementation of the programmable gain amplifiers PGA and the channel selection filters as depicted in Fig. 1 requires approx. 14 operational amplifiers for the analog baseband unit. Further operational amplifiers and/or transconductors are required for the analog/digital converter ADC.

Fig. 2 shows a basic circuit diagram of an operational amplifier according to the prior art. Here, the operational amplifier OA is biased by a biasing circuit BC. The transconductance of a MOS transistor biased in saturation region is given by

$$\text{gm} = \sqrt{2I_{ds}K} \qquad (1)$$

wherein $I_{ds}$ is the drain-to-source current and wherein K = $\mu_0 C_{ox}$W/L is the transconductance of the MOS transistor, wherein $\mu_0$ is the mobility of the carriers, Cox is the gate capacitance per unit area, W and L are the width and the length of the MOS transistor, respectively. The value of the parameter K depends on the process and temperature. The temperature dependency of the carrier mobility is $\mu_0 \propto 1 / T^\gamma$, wherein for most processes $\gamma$ = 1,5 ... 2,0.

The biasing circuit BC according to Fig. 2 outputs a biasing current for the MOS transistors. The bias current can either be a constant DC current or a current which is proportional to the absolute temperature (PTAT), to establish a desired operating point for the MOS transistors. A constant bias current is usually generated from a reference voltage source, e.g. a bandgap voltage related to an on-chip or external resistor. On the other hand, the PTAT current is generated based on the exponential current-voltage characteristics of MOS transistors in weak inversion.

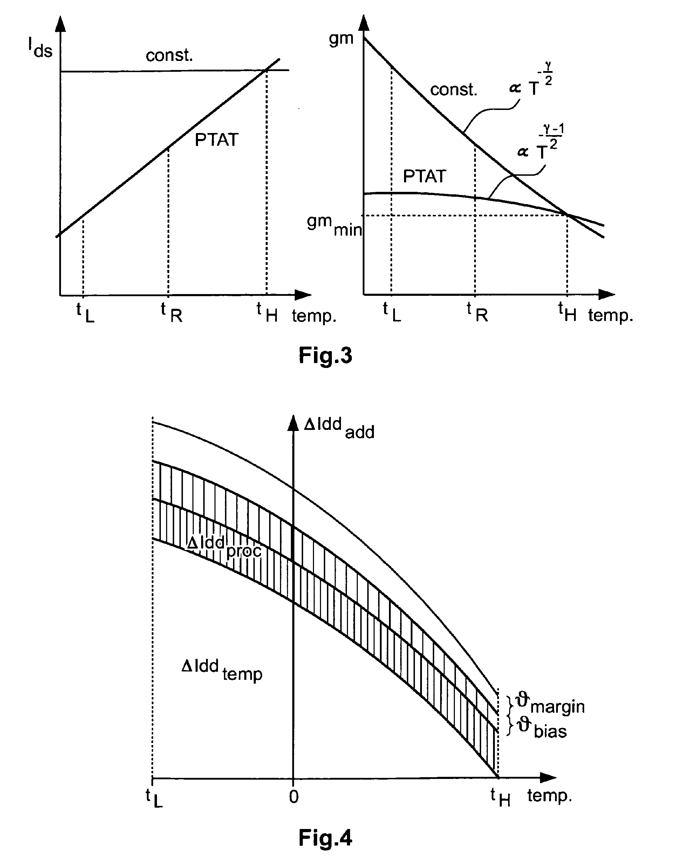

Fig. 3 shows a graph of the dependency of the bias current and the transconductance versus temperature. On the left hand side, the bias current versus temperature is depicted. On the right hand side, the transconductance of a MOS transistor versus temperature is depicted. As temperature increases, the transconductance gm with a constant drain current $I_{ds}$ decreases more rapidly than that with a PTAT current because the PTAT current increases with temperature and can therefore compensate the decrease the parameter K. Accordingly, the transconductance of a MOS transistor with a PTAT bias current shows a less steep slope than a transconductance with a constant bias current.

As MOS transistors are subject to both process and temperature variations, all analog circuits have to fulfill worst case conditions, e.g. a minimum transconductance $gm_{min}$. The respective bias current has to be designed such that $gm \geq gm_{min}$ is achieved over entire temperature range $t_L$-$t_H$. This is depicted in the right hand side diagram of Fig. 3, where the transconductance obtained with a constant bias current and the transconductance obtained with a PTAT current meet at $t = t_H$ where $gm = gm_{min}$.

It should be noted that constant bias current is less power efficient than a PTAT bias current.

The total current consumption of any analog circuits can be expressed as:

$$Idd_{total} = (1 + \vartheta_{bias} + \vartheta_{margin})(Idd_{min} + \Delta Idd_{temp} + \Delta Idd_{proc}) \qquad (3)$$

wherein $Idd_{min}$ corresponds to the absolute minimum current, $\Delta Idd_{temp}$ corresponds to the amount of current which is additionally needed to maintain the required transconductance over the entire temperature range, $\Delta Idd_{proc}$ corresponds to the current additionally required to maintain the required transconductance over process variations. The bias current is also affected by temperature and process variations which need to be taken into account. To deal with these variations, the bias current is typically increased by a factor $\vartheta_{bias}$. Moreover, a safety margin $\vartheta_{bias}$ needs to be added to increase the robustness.

Fig. 4 shows a graph of wasted current in a typical analog circuit for a constant biasing. At temperature $t = t_H$, $\Delta Idd_{temp} = 0$. On the other hand, at temperature $t = t_L$, both the transconductance and the wasted current reach a respective maximum. As most analog circuits are designed using constant biasing, a lot of power is wasted especially at lower temperatures.

For any analog circuits, the relationship between the total current consumption and the biasing current can be expressed:

$$Idd_{total} = \beta \cdot I_{bias} \qquad (4)$$

wherein $\beta > 1$. In other words, the total power consumption is proportional to the biasing current, and minimizing bias current can minimize the total current.

US 5,777,518 is related to a method of biasing a MOSFET amplifier in order to obtain a constant transconductance. A first transistor M 1 is operated in a triode region to provide a gate-source voltage for a second transistor biased in the saturation region. As a result, the accuracy of the biasing suffers.

SUMMARY OF THE INVENTION

It is therefore an object of the invention to provide an electronic device or an integrated circuit with an analog circuitry which can be biased with higher precision at a lower power consumption.

This object is solved by an electronic device according to claim 1, by an integrated circuit according to claim 4 and a method of biasing at least one MOS transistor in an integrated circuit according to claim 5.

An electronic device is provided which comprises at least one integrated circuit with at least one MOS transistor. The electronic device furthermore comprises an adaptive analog biasing unit for providing an adaptive biasing current for the at least one MOS transistor biased in the saturation region. The adaptive analog biasing unit is arranged on the same chip together with the integrated circuit and comprises a process monitor unit for extracting a device parameter of the integrated circuit and a calculation unit, for generating a bias current based on the output of the process monitor unit. The bias current generated by the calculation unit is inversely proportional to the extracted device parameter.

According to an aspect of the invention, the device parameter equals to $\mu_0 C_{ox} W/L$, wherein $\mu_0$ is the mobility of the carriers, $C_{ox}$ is the gate capacitance per unit area, W and L are the width and the length of the MOS transistor, respectively.

According to still a further aspect of the invention, the process monitor unit comprises a threshold voltage extraction unit for extracting the threshold voltage and a device parameter extraction unit for extracting the device parameter. The threshold voltage extraction unit receives a DC input voltage and its output voltage corresponds to the sum of the DC input voltage and the extracted threshold voltage. The device parameter extraction unit comprises a MOS transistor and receives the output voltage of the threshold voltage extraction unit as input, which is applied to the gate of the MOS transistor such that the drain current of the MOS transistor is proportional to the device parameter. The drain current of the MOS transistor constitutes the output of the process monitor unit.

The invention also relates to an integrated circuit comprising at least one MOS transistor and an adaptive analog biasing unit for providing an adaptive biasing current for the at least one MOS transistor biased in the saturation region. The adaptive analog biasing unit comprises a process monitor unit for extracting a device parameter of the integrated circuit and a calculation unit for generating a bias current based on the output of the process monitor unit. The bias current generated by the calculation unit is inversely proportional to the extracted device parameter.

The invention also relates to a method of biasing at least one MOS transistor in an integrated circuit. The at least one MOS transistor is adaptively biased in the saturation region. A device parameter of the integrated circuit is extracted. A bias current is generated which is inversely proportional to the extracted device parameter.

The present invention relates to the idea to provide an adaptive analog biasing for automatically adjusting the bias current of MOS transistors which are operating in the saturation region at a lower power consumption while maintaining the desired transconductance over process and temperature variations. This adaptive analog biasing can be implemented in any CMOS process technology and finds applications in analog circuitry and in RF CMOS front-end circuits. MOS transistors are biased adaptively depending on the actual process parameter of each individual sample as well as depending on the temperature to minimize the power consumption while guaranteeing its performance. This can be achieved by a process monitor extracting process parameters and outputting a current $I_{ex}$. The optimum bias current is generated based on the extracted process parameter.

Further aspects of the invention are defined in the dependent claims.

BRIEF DESCRIPTION OF THE DRAWINGS

Advantages and embodiments of the present invention will now be described in more detail with reference to the figures.

Fig. 1    shows a schematic diagram of a heterodyne UMTS receiver according to the prior art,
Fig. 2    shows an input differential pair and a biasing curcuit according to the prior art,
Fig. 3    shows a graph of the dependence on the bias current and the transconductance versus temperature,
Fig. 4    shows a graph of wasted current of an analog circuit with constant biasing,
Fig. 5    shows a block diagram of an analog biasing circuit according to a first embodiment,
Fig. 6    shows a detailed schematic of the analog biasing circuit according to Fig. 5,
Fig. 7    shows a schematic of a two-stage operation amplifier according to a second embodiment,
Fig. 8    shows a graph of the amplitude and phase characteristics of a third embodiment,
Fig. 9A   shows a schematic of a two stage operational amplifier according to a fourth embodiment,
Fig. 9B   shows a schematic of a linearized differential transconductor,
Fig. 10   shows a graph of a simulated power reduction according to a fifth embodiment, and
Fig. 11   shows a graph depicting Monte Carlo simulation results according to a sixth embodiment.

DETAILED DESCRIPTION OF EMBODIMENTS

The embodiments of the present application relate to the idea to provide an adaptive analog biasing for MOS transistors, e.g. in analog circuits, such as analog baseband circuits or in RF CMOS front-end circuits. The biasing of the MOS transistors is controlled by the drain-source current of the respective MOS transistor. If the drain current of a MOS transistor operating a saturation is set that

$$I_{ds} \propto 1/K \qquad (5)$$

the transconductance gm of the MOS transistor will be independent of the temperature variations and process deviations. This can be achieved by measuring the process parameter K on chip and by generating a bias current inversely proportional to the measured process parameter K, wherein this bias current is used to bias the MOS transistors.

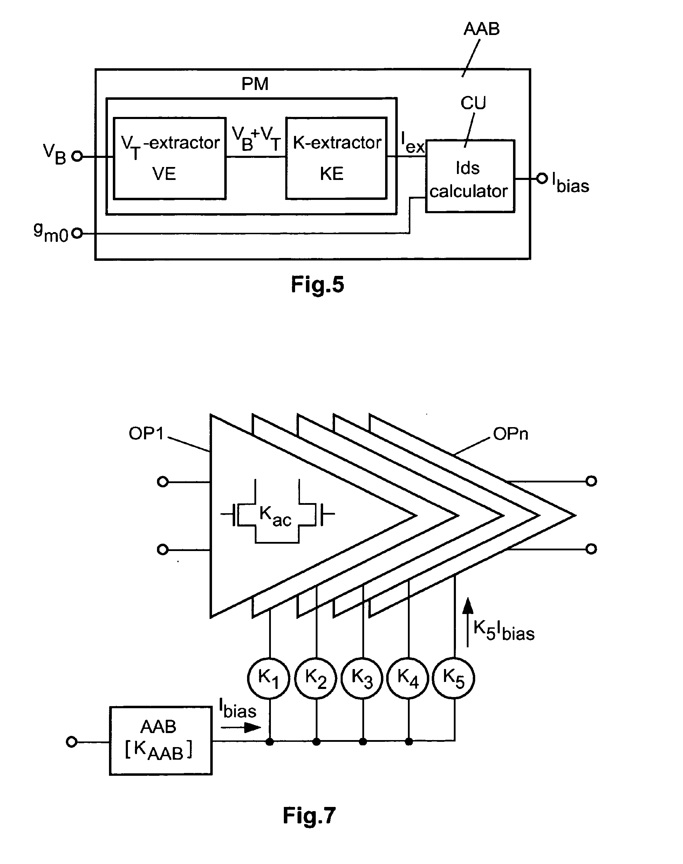

Fig. 5 shows a block diagram of an adaptive analog biasing circuit according to the first embodiment. The adaptive analog biasing circuit AAB comprises a process monitor unit PM and a calculator unit CU. The calculator unit serves to calculate the drain current of a MOS transistor. The process monitor unit PM comprises a Vt extractor unit VE and a K extractor unit KE. The process monitor unit PM outputs a current $I_{ex}$ to the calculator unit CU. The calculator unit CU generates the bias current such that the desired transconductance is obtained and is maintained for all parts and at all temperatures. The output of the analog biasing circuit AAB is

$$I_{bias} = \frac{gm_0^2}{I_{ex}} \qquad (6)$$

wherein $gm_0$ is the desired transconductance and wherein $I_{ex}$ is proportional to K. By substituting the equation (6) into equation (1), a transconductance gm is yielded, which is kept constant.

The bias monitor unit PM and the calculator unit CU are implemented on chip. For more details on the implementations of this two extractor circuits VE, KE, please refer to "Z. Wang: "Automatic VT-extraction based on an n x n2 MOS transistor array and their application", IEEE J. Solid-State Circuits, vol. 27, no. 9, pp. 1277-1285, 1992" and "Z. Wang: "Direct, fast and accurate measurement of VT and K of an MOS transistor using a VT-sift circuit", IEEE Trans. Instrum. Meas., vol. 40, no. 6, pp. 951-955, 1991", which are incorporated herein by reference.

It should be noted, that the two extractor circuits VE and KE output the extracted $V_T$ and K in voltage and current, respectively without any computation and computation delay.

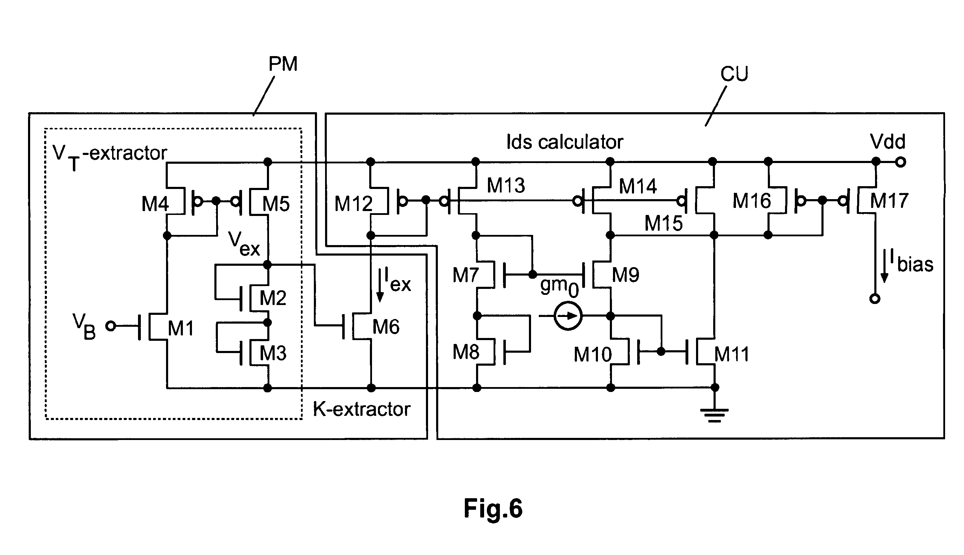

Fig. 6 shows a detailed schematic of the adaptive analog biasing circuit of Fig. 5. Transistors M1 - M3 and M6 operate in saturation region with the size relationship $(W/L)_2 = (W/L)_3 = 4\,(W/L)_1 = 4\,(W/L)_6$. The transistors M4 and M5 constitute a current mirror with unity gain. With these sizes and for an input DC voltage $V_B$, the output of the $V_T$-extractor VE corresponds to $V_{ex} = V_B = V_T$.

If this voltage is applied to the gate of transistor M6, its drain current is:

$$I_{ex} = \frac{K_{AAB}V_B^2}{2} \qquad\qquad (7)$$

wherein the drain current is proportional to parameter $K_{AAB}$.

The calculator unit CU serves to perform a division operation according to eq. (6). The calculator unit CU may also be implemented using a current squarer instead. Here, the transistors M7 - M11 have identical sizes and also work in the saturation region. A multi-output current mirror (transistors M12 - M15) is used to set the drain current of each transistor equal to the output of the process monitor PM, namely the current $I_{ex}$. The common nodes of M9 and M10 are supplied with an input DC current, which corresponds to the desired transconductance $gm_0$. A second current mirror (transistor M 16 and M 19) outputs the bias current for an analog circuit as follows:

$$I_{bias} = \wp\,\frac{gm_0^2}{K_{AAB}} \qquad\qquad (8)$$

with

$$\wp = \frac{1}{4V_B^2} \qquad\qquad (9)$$

If the transconductance of a MOS transistor in an operational amplifier corresponds to $K_{ac}$ and if its drain current corresponds to $\kappa$ times $I_{bias}$, the transconductance is:

$$gm_{ac} = \sqrt{\kappa\,\frac{K_{ac}}{K_{AAB}}}\,gm_0 \qquad\qquad (10)$$

In other words, any required transconductance can be obtained by selecting $K_{ac}$ or $\kappa$ or both.

Fig. 7 shows an example where several operational amplifiers are used according to a second embodiment. Here, operational amplifiers OP1 - OPn are coupled to the adaptive analog biasing circuit AAB, which serves to output a biasing current Ids according to equation (8). By multiplying the bias current with proper values $\kappa_1 - \kappa_5$, the bias current for each operational amplifier can be set individually. In particular, the biasing current for each output stage can be scaled by a proper aspect ratio of the relevant current mirror.

If the voltage $V_B = 1/\sqrt{2} = 0{,}707$ V, equation (10) can be simplified to

$$I_{bias} = \frac{gm_0^2}{K_{AAB}} \qquad (11)$$

If $\kappa K_{ac} = K_{AAB}$, the equation (10) can be reduced to:

$$gm_{ac} = gm_0 \qquad (12)$$

Accordingly, a MOS transistor of the same size as transistors M1 or M6 will have the transconductance equal to the value of the input current $gm_0$.

In addition to the lowest power consumption, the robustness of the analog circuits have been improved. This will be described later in more detail.

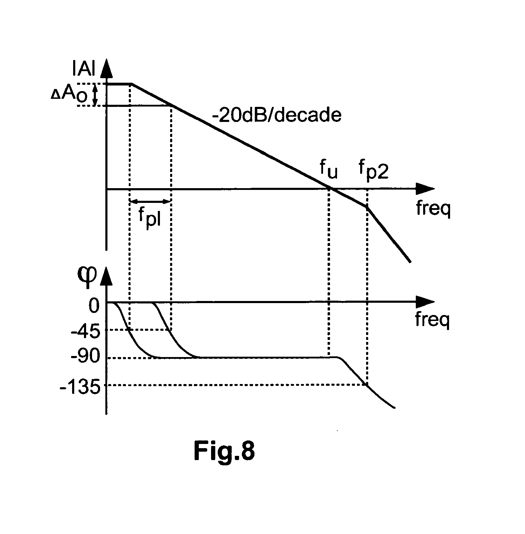

Fig. 8 shows a graph of amplitude and phase characteristics according to a fourth embodiment. Here, a second-order system is depicted. The system will remain stable if the phase margin remains > 60° and the second pole is located at a frequency > 2,2 $f_u$.

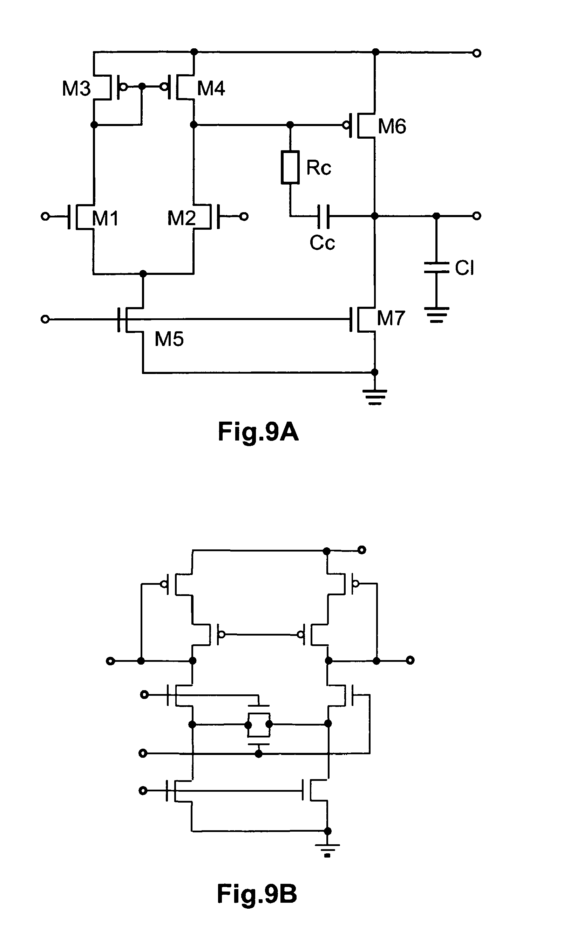

Fig. 9A shows a two-stage CMOS operational amplifier. The operational amplifier comprises transistors M1 - M7, two capacitors Cc and Cl as well as a resistor Rc. The DC gain of this operational amplifier is

$$Ao = gm2 \cdot gm6/(gd2 + gd4)(gd6 + gd7) \qquad (13)$$

The unity gain frequency thereof is

$$f_u = gm1/(2\pi Cc) \qquad (14)$$

wherein gm1 corresponds to the transconductance of the input differential pair and wherein Cc corresponds to the Miller compensation capacitance. The second pole is located at:

$$f_{p_2} = gm6/2\pi C_L \qquad (15)$$

When the analog biasing circuit AAB according to Fig. 5 or 6 is used, the transconductance gm1 and gm6 can be maintained constant and unchanged irrespective of process variations and temperature variations. In other words, the frequencies $f_u$ and $f_{p2}$ are kept unchanged if the capacitances Cc and $C_L$ are constant.

Fig. 9B shows a circuit schematic of a linearized differential transconductor. This transconductor is widely used in continuous time $\Sigma/\Delta$ ADC and continuous-time gm-C filters.

Table 1 shows a comparison of constant biasing, PTAT biasing and adaptive analog biasing according to the invention.

Table 1

| biasing scheme | | constant Ids = const. | PTAT Ids ∝ KT/q | AAB Ids ∝ 1/K |
|---|---|---|---|---|
| General | gm = √2·Ids·K | ∝ √K | ∝ √KT | const. |
| | go ≈ λ·Ids | const. | ∝ T | ∝ 1/K |
| 2-stage op-amp (Fig. 9A) | $f_u$ = gm1/(2πCc) | ∝ √K | ∝ √KT | const. |
| | $f_{p2}$ = gm6/(2π$C_L$) | ∝ √K | ∝ √KT | const. |
| linearized transconductor (Fig. 9B) | gm = √Ids·K/2 | ∝ √K | ∝ √KT | const. |

In particular, the frequencies $f_u$ and $f_{p2}$ of the operational amplifier according to Fig. 9A and gm of the linearized differential transconductor according to Fig. 9B are compared to those values for constant biasing, for PTAT biasing and for the biasing according to Fig. 5 and 6. In table 1, the values of the transconductance gm and go are compared. Accordingly, it can be seen that by using the adaptive analog biasing circuit AAB, the robustness of the overall system is increased.

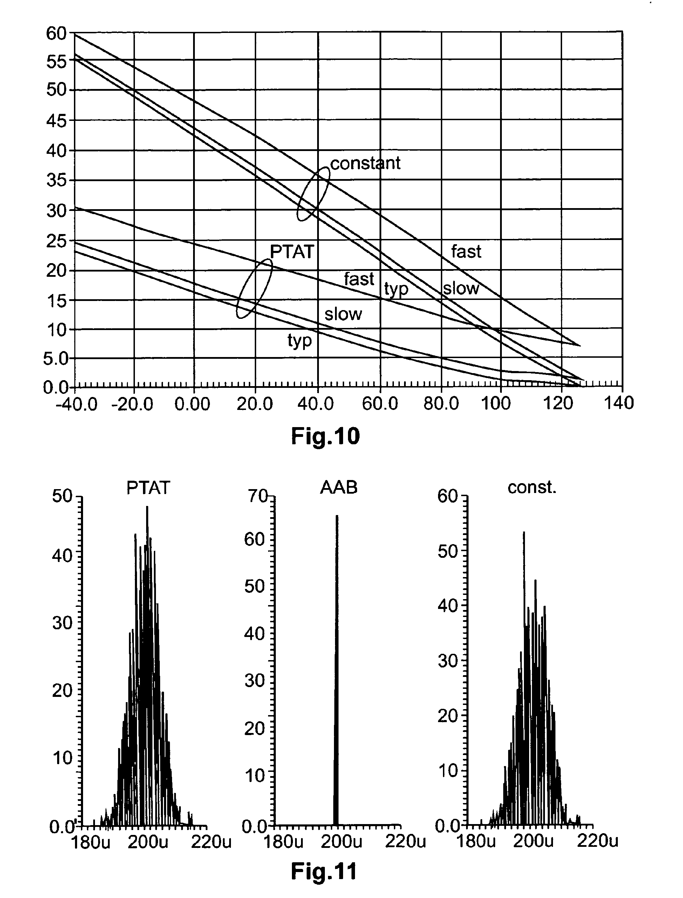

Fig. 10 shows a graph of the expected power reduction with adaptive analog biasing according to a fifth embodiment. At a temperature t = 125°C, all three bias currents are equal resulting in an equal transconductance gm. In Fig. 10, with adaptive analog biasing, the power reduction of a system with respect to conventional constant biasing and a PTAT biasing for slow, normal and fast processes are shown. It is seen that a power reduction of up to 31 % to 60% can be achieved.

Fig. 11 shows a graph of Monte Carlo simulation results of transconductance distribution due to process variations for constant biasing, PTAT biasing and an adaptive analog biasing according to the invention. In the middle of the graph, the Monte Carlo simulation based on the biasing according to the invention is depicted. On the left side, the result of a PTAT biasing is depicted and on the right, the result of a constant biasing is depicted. The total number of runs is 1000. All three bias currents were set equal to correspond to gm = 200$\mu$A/V. The simulation results show a Gaussian distribution with a mean value of 200$\mu$A/V with all three biasing schemes. For the PTAT biasing the standard deviation is 4,68413$\mu$, for the constant biasing the standard deviation is 4,64179 $\mu$ and for the adaptive analog biasing according to the invention, the standard deviation is reduced to 191,677n by a factor of 24.

The adaptive analog biasing can be used for biasing MOS transistors in the RF CMOS front-end circuit FE and the analog baseband circuit AB as shown in Fig. 1.

The application of the above described adaptive analog biasing circuit is virtually endless, including (but is not limited to) analog baseband circuits, switched-capacitor (SC) filters, switched-capacitor $\Sigma/\Delta$ analog/digital converters ADC, continuous-time RC filters, continuous-time gm-C filter, continuous-time $\Sigma/\Delta$ ADC, automatic gain control AGC, amplifiers or poly-phase filters and last but not least in RF CMOS front-end circuits, LNA, mixers etc.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. In the device claim enumerating several means, several of these means can be embodied by one and the same item of hardware. The mere fact that certain measures are recited in mutually different dependent claims does not indicate that a combination of these measures cannot be used to advantage.

Furthermore, any reference signs in the claims shall not be constrained as limiting the scope of the claims.

**Claims**

1. Electronic device, comprising:

   at least one integrated circuit comprising at least one MOS transistor, and
   an adaptive analog biasing unit (AAB) for providing an adaptive biasing current for the at least one MOS transistor biased in the saturation region;
   wherein the adaptive analog biasing unit (AAB) is arranged on a chip together with the integrated circuit and comprises a process monitor unit (PM) for extracting a device parameter (K) of the integrated circuit and a calculation unit (CU) for generating a bias current based on the output of the process monitor unit (PM),
   wherein the bias current generated by the calculation unit (CU) is inversely proportional to the extracted device parameter (K).

2. Electronic device according to claim 1, wherein
   the device parameter (K) equals $\mu_0 C_{ox} W/L$,
   wherein $\mu_0$ is the mobility of the carriers, $C_{ox}$ is the gate capacitance per unit area, W and L are the width and the length of the MOS transistor, respectively.

3. Electronic device according to any one of the claims 1 to 2, wherein
   the process monitor unit (PM) comprises a threshold voltage extraction unit (VE) for extracting the threshold voltage and a device parameter extraction unit (KE) for extracting the device parameter (K),
   wherein the threshold voltage extraction unit (VE) receives an DC input voltage ($V_a$) and its output voltage corresponds to the sum of the DC input voltage ($V_B$) and the threshold voltage ($V_T$),
   wherein the device parameter extraction unit (KE) comprises a MOS transistor (M6) and receives the output voltage of the threshold voltage extraction unit (VE) as input which is applied to the gate of the MOS transistor (M6) such that the drain current of the MOS transistor (M6) is proportional to the device parameter (K),
   wherein the drain current of the MOS transistor (M6) constitutes the output of the process monitor unit (PM).

**4.** Method of biasing at least one MOS transistor in an integrated circuit, comprising the steps of:

adaptive biasing the at least one MOS transistor in the saturation region by extracting a device parameter (K) of the integrated circuit and

generating a bias current which is inversely proportional to the extracted device parameter (K).

**Patentansprüche**

**1.** Elektronische Vorrichtung, die Folgendes umfasst:

wenigstens eine integrierte Schaltung mit wenigstens einem MOS-Transistor und

eine adaptive analoge Vorspannungseinheit (AAB), um einen adaptiven Vorspannungsstrom für den wenigstens einen MOS-Transistor, der im Sättigungsbereich vorgespannt ist, bereitzustellen;

wobei die adaptive analoge Vorspannungseinheit (AAB) auf einem Chip zusammen mit der integrierten Schaltung angeordnet ist und eine Prozessüberwachungseinheit (PM), um einen Vorrichtungsparameter (K) der integrierten Schaltung zu extrahieren, und eine Recheneinheit (CU), um anhand des Ausgangs der Prozessüberwachungseinheit (PM) einen Vorspannungsstrom zu erzeugen, umfasst,

wobei der Vorspannungsstrom, der durch die Recheneinheit (CU) erzeugt wird, zu dem extrahierten Vorrichtungsparameter (K) umgekehrt proportional ist.

**2.** Elektronische Vorrichtung nach Anspruch 1, wobei der Vorrichtungsparameter (K) gleich $\mu_0 C_{ox} W/L$ ist,

wobei $\mu_0$ die Trägerbeweglichkeit ist, $C_{ox}$ die Gate-Kapazität pro Einheitsfläche ist und W und L die Breite bzw. die Länge des MOS-Transistors sind.

**3.** Elektronische Vorrichtung nach einem der Ansprüche 1 bis 2, wobei

die Prozessüberwachungseinheit (PM) eine Schwellenspannungs-Extraktionseinheit (VE), um die Schwellenspannung zu extrahieren, und eine Vorrichtungsparameter-Extraktionseinheit (KE), um den Vorrichtungsparameter (K) zu extrahieren, umfasst,

wobei die Schwellenspannungs-Extraktionseinheit (VE) eine Eingangsgleichspannung ($V_B$) empfängt und wobei ihre Ausgangsspannung der Summe aus der Eingangsgleichspannung ($V_B$) und der Schwellenspannung ($V_T$) entspricht,

wobei die Vorrichtungsparameter-Extraktionseinheit (KE) einen MOS-Transistor (M6) enthält und die Ausgangsspannung der Schwellenspannungs-Extraktionseinheit (VE) als einen an das Gate des MOS-Transistors (M6) angelegten Eingang empfängt, so dass der Drain-Strom des MOS-Transistors (M6) zu dem Vorrichtungsparameter (K) proportional ist,

wobei der Drain-Strom des MOS-Transistors (M6) den Ausgang der Prozessüberwachungseinheit (PM) bildet.

**4.** Verfahren zum Vorspannen wenigstens eines MOS-Transistors in einer integrierten Schaltung, das die folgenden Schritte umfasst:

adaptives Vorspannen des wenigstens einen MOS-Transistors im Sättigungsbereich durch Extrahieren eines Vorrichtungsparameters (K) der integrierten Schaltung und

Erzeugen eines Vorspannungsstroms, der zu dem extrahierten Vorrichtungsparameter (K) umgekehrt proportional ist.

**Revendications**

**1.** Dispositif électronique comprenant :

au moins un circuit intégré comprenant au moins un transistor MOS, et

une unité de polarisation analogique adaptative (AAB) pour fournir un courant de polarisation adaptatif pour ledit au moins un transistor MOS polarisé dans la région de saturation ;

dans lequel l'unité de polarisation analogique adaptative (AAB) est placée sur une puce en même temps que le circuit intégré et comprend une unité de surveillance de processus (PM) pour extraire un paramètre de dispositif (K) du circuit intégré et une unité de calcul (CU) pour générer un courant de polarisation basé sur la sortie de l'unité de surveillance de processus (PM),

dans lequel le courant de polarisation généré par l'unité de calcul (CU) est inversement proportionnel au paramètre de dispositif (K) extrait.

2. Dispositif électronique selon la revendication 1, dans lequel :

le paramètre de dispositif (K) est égal à $\mu_0 C_{ox}$ W/L,
dans lequel $\mu_0$ est la mobilité des porteurs, $C_{ox}$ est la capacité de grille par surface unitaire, W et L sont respectivement la largeur et la longueur du transistor MOS.

3. Dispositif électronique selon l'une quelconque des revendications 1 et 2, dans lequel :

l'unité de surveillance de processus (PM) comprend une unité d'extraction de tension de seuil (VE) pour extraire la tension de seuil et une unité d'extraction de paramètre de dispositif (KE) pour extraire le paramètre de dispositif (K),
dans lequel l'unité d'extraction de tension de seuil (VE) reçoit une tension d'entrée continue ($V_B$) et sa tension de sortie correspond à la somme de la tension d'entrée continue ($V_B$) et de la tension de seuil ($V_T$),
dans lequel l'unité d'extraction de paramètre de dispositif (KE) comprend un transistor MOS (M6) et reçoit en entrée la tension de sortie de l'unité d'extraction de tension de seuil (VE) qui est appliquée à la grille du transistor MOS (M6) de telle manière que le courant de drain du transistor MOS (M6) est proportionnel au paramètre de dispositif (K),
dans lequel le courant de drain du transistor MOS (M6) constitue la sortie de l'unité de surveillance de processus (PM).

4. Procédé de polarisation d'au moins un transistor MOS dans un circuit intégré, comprenant les étapes suivantes :

polarisation adaptative dudit au moins un transistor MOS dans la région de saturation par extraction d'un paramètre de dispositif (K) du circuit intégré et
génération d'un courant de polarisation qui est inversement proportionnel au paramètre de dispositif (K) extrait.

**Fig.1**

**Fig.2**

**Fig.3**

**Fig.4**

AAB

PM

CU

$V_B$ o— | $V_T$-extractor VE | $V_B+V_T$ | K-extractor KE | $I_{ex}$ | Ids calculator | —o $I_{bias}$

$g_{m0}$ o—

**Fig.5**

OP1

OPn

$K_{ac}$

$K_5 I_{bias}$

$K_1$ $K_2$ $K_3$ $K_4$ $K_5$

AAB
[$K_{AAB}$] | $I_{bias}$

**Fig.7**

Fig.6

**Fig.8**

**Fig.9A**

**Fig.9B**

**Fig.10**

**Fig.11**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5777518 A

### Non-patent literature cited in the description

- **Z. WANG.** Automatic VT-extraction based on an n x n2 MOS transistor array and their application. *IEEE J. Solid-State Circuits,* 1992, vol. 27 (9), 1277-1285

- **Z. WANG.** Direct, fast and accurate measurement of VT and K of an MOS transistor using a VT-sift circuit. *IEEE Trans. Instrum. Meas.,* 1991, vol. 40 (6), 951-955